# EUROPEAN PATENT SPECIFICATION

(11) **EP 1 719 153 B1**
(45) Date of publication and mention of the grant of the patent: **21.10.2009**
(21) Application number: 05712656.7
(22) Date of filing: 03.02.2005
(51) Int. Cl.: H01L 21/00

(54) **PURGING OF A WAFER CONVEYANCE CONTAINER**
REINIGEN EINES WAFER-ÜBERFÜHRUNGSBEHÄLTERS
PURGE D'UN RECIPIENT DE TRANSFERT DE PLAQUETTES

(30) Priority: 05.02.2004 US 542032 P
(43) Date of publication of application: 08.11.2006
(60) Divisional application: 09170473.4
(73) Proprietor: Entegris, Inc., Chaska, MN 55318 (US)
(72) Inventor: SPIEGELMAN, Jeffrey, J., San Diego, CA 92130 (US); ALVAREZ, Daniel, Jr., San Diego, CA 92126 (US); HOLMES, Russell, J., Santee, CA 92071 (US)
(74) Representative: Gambell, Derek
(86) International application number: PCT/US2005/003287
(87) International publication number: WO 2005/078771

(56) References cited:
- EP-A- 1 067 583
- EP-A- 1 182 694
- US-A- 5 169 272
- US-A- 5 644 855
- US-A1- 2002 124 906

## Description

### BACKGROUND OF THE INVENTION

The present invention relates to the purging of high purity environments to remove contamination. More specifically, the present invention provides a method for purging a standardized mechanical interface pod to ensure the quality of the environment therein. The invention particularly pertains to the purging of a container for semiconductor devices, wafers, flat panel displays, and other products requiring high purity environments while the container interfaces with a process tool or other sealed chamber.

In the fabrication of semiconductor devices the silicon wafers undergo many process steps to build the layers of material necessary for the device. Each process step requires a separate tool to perform the task and the wafers must be transported between these process tools. The reduction in feature dimensions on the wafers has driven the constantly increasing purity of the gases, chemicals, and environments that contact the wafers during each process step. Since the cleanroom environment is considerably less pure than the surface of the wafer, the exposure of the wafers to cleanroom air during transport is detrimental to the process, resulting in defects and wafer loss. The standardized mechanical interface (SMIF) system has provided a solution to the transport of wafers in the open cleanroom.

While impurity tolerance levels vary from process to process, in most process tools the advantage of point of use purification is clear. Process gases are often transported to the tool over long distances of piping throughout the fabrication facility, the greater the distance traveled the more likely that contaminants will become entrained in the stream. Furthermore, it is often not feasible for suppliers to provide gases of high enough purity to the fabrication facility. Even in cases where the production of gas of sufficient purity is practical, the likelihood of contamination during transport and installation often precludes the direct use of this gas. Therefore, many inventions exist in the prior art for the point of use purification of nearly all of the gases used in the process tools. The incorporation of these methods and devices into process tools has become standard practice in the industry.

To ensure cleanliness and for ease of transport, the wafers are typically contained within a standardized container as they travel to different process tools. The two most common types of these containers are standard mechanical interface (SMIF) pods and front opening unified pods (FOUPs). The SMIF system decreases wafer contamination by protecting the wafers from particulate contamination and providing a standardized and automated interface with the clean environment of the process tool. In the SMIF system the wafers or other sensitive devices, such as flat panel displays, are contained within the pod, which is composed of polycarbonate plastic. A typical FOUP has a capacity of 10-25 wafers, which are secured on individual shelves. The FOUP is connected to the process through an interface device or "port," such as the Isoport^{®} available from Asyst Technologies. The Isoport provides a kinematic coupling mechanism to align the FOUP with the tool and an automated door to open and close the FOUP for access to the wafers. Once opened, the FOUP environment comes into contact with the tool environment and the interface is generally purged by positive flow from the process tool.

Despite the purging of the interface between the FOUP and the process tool, the FOUP environment is still susceptible to impurities, both particulate and airborne molecular contaminants (AMCs), from a number of sources. The FOUP is made of a polycarbonate plastic body that is sealed to an aluminum base. The seals and resins used in the FOUP may outgas contaminants, especially contaminants absorbed during the wet rinse process in which FOUPs are cleaned. During the process step, the wafers are continuously removed from and returned to the FOUP. Depending upon the process occurring in the tool a variety of contaminants may be retained on the surface of the wafer. As the wafers rest in the FOUP, especially if they are stored for an extended time, these contaminants may be released into the FOUP environment and contaminate additional wafers or portions of the wafer. Also, as the wafers rest in the FOUP, outside air leaks into and contaminant the FOUP environment. For reasons of safety and handling, FOUPs are not constructed to be hermetically sealed.

A separate purge specifically for the FOUP has not been incorporated into the design of Isoport stations, because experimental evidence has supported the idea that purging the FOUP is detrimental to the wafers. Veillerot, et. al. ("Testing the use of purge gas in wafer storage and transport containers," [online] 1997-2003; on the Internet <URL: http://www.micromagazine.com/archive/03/08/verllerot.html) conducted a study in which they examined the effects of SMIF pod purging with clean dry air containing < 2 ppb hydrocarbon contaminants and nitrogen containing 300 ppt hydrocarbon contaminants. Based on electrical measurements on wafers stored with and without purging, they concluded that a static environment is better than a purged container. Thus, purging of FOUPs with gas at this purity level is clearly undesirable.

In patents issued to Asyst Technologies a number of valve arrangements, sensors, and actuators have been disclosed for incorporating purge gas flow to the FOUP when it is present on the stage of the Isoport. The focus of these inventions is the introduction of purging to the Isoport without regard for control of the purge conditions. The conditions for administering purge gas are crucial to the success of the method. In addition to complications arising from gas that is not of a certain purity level, the starting and stopping of purge gas flow introduces new complications arising from the turbulent flow of gas within the FOUP. This turbulent flow, which occurs whenever gas is instantly made to flow across a pressure differential, causes particles that have settled on the bottom of the FOUP to become entrained in the stream and to subsequently settle on the surface of the wafers. As a result of purging the wafers become contaminated, resulting in defects and lost wafers. The Asyst patents clearly are a novel means to interface purge gas flow with the FOUP, but it is not practical without proper control of the purge conditions.

In U.S. Patent Number 5,346,518 issued to IBM Corp. an elaborate system of adsorbents and filters is disclosed whereby contaminants, specifically hydrocarbons are removed from the environment within a SMIF pod. The invention involves many embodiments with alternative adsorbent arrangements to compensate for variables that might be encountered in different processes and SMIF pods. While the invention provides a novel means of protecting the FOUP environment, some major drawbacks exist when using this method. The vapor removal elements or adsorbents described in this invention rely on the diffusive transport of contaminants to them under static conditions. Therefore, the residence time of the contaminants within the FOUP may be long and certain contaminants that are irreversibly bound to the wafer surfaces will not be efficiently removed. Even if the contaminants are reversibly bound to the wafer surface, the wafer surface may still reach a quasi-steady level of contamination that is difficult to remove using a purely diffusive process. The adsorbents themselves typically rely on reversible equilibrium adsorption conditions to remove contaminants from the FOUP environment. Therefore, as contaminants become concentrated on the adsorbents they may be released into the FOUP environment. This complication is prevented by periodically replacing the adsorbents, thereby creating a new process step. Additionally, since replacement is dependant on time rather than contaminant concentration, the method is susceptible to the effects of process irregularities. For example, a system upset may result in a large amount of impure gas entering the FOUP, such as from process tool purge gas. The impurities in this gas may saturate the absorbents in the FOUP and result in their inoperability before their scheduled replacement. Since FOUPs are normally cleaned in a wet rinse process, the adsorbents must be removed or otherwise protected prior to this process. Thus, this method of contamination control possesses considerable disadvantages when compared to purging of FOUPs under the proper conditions, but the two methods are mutually exclusive.

We are aware of United States patent application US2002/124906 (Suzuki et al.) which describes a method of using a substrate transport pod is provided, which is suitable for manufacturing semiconductor devices with copper wiring and low dielectric insulating film having dielectric constants of less than 3. The method is based on loading the substrates into a pod from an atmosphere of a first process, and circulating a gaseous atmosphere through interior of the pod in such a way to selectively remove at least one contaminant including moisture, particulate substances or chemical substances, and to expose the substrates to a controlled atmosphere intermittently or continually while the substrates are held in the pod before unloaded from the pod and introduced into a second process. For a pod that is used to house the substrates for the purpose of retaining or transporting, the pod has a pod main body and a door that provides a hermetic sealing, and the pod is made primarily of a materiel that has moisture absorption factor of less than 0.1%, and the pod can contact the substrates directly or indirectly and has a conductive area so as to enable static charges to be guided out of the pod.

We are also aware of European patent publication EP1067583 (Ebra Corp.) which describes a substrate transport container having a carrier box including a container body and a door hermetically sealably covering an opening provided in the front of the container body. Partitions form a circulating flow path in the carrier box. The circulating flow path has a flow path in which air flows toward substrates and a flow path in which air flows toward a fan. A substrate carrying section is disposed in the flow path in which air flows toward the substrates to carry the substrates in such a wary that the principal surfaces of the substrates are approximately parallel to the flow path in which air flows toward the substrates. A particle removing filter and a gaseous impurity trapping filter are placed on the upstream side of the substrate carrying section in the flow path in which air flows toward the substrates. A fan motor for driving the fan is incorporated in the carrier box to form an air current for circulating through the circulating flow path.

Further, we are aware of United States patent US 5 644 855 (McDermott et al.) which describes a portable contamination-sensitive component transport container provides a continuously purged environment for the components. The container includes an attached cryogenically liquefied inert gas insulated storage vessel from which vaporized liquefied inert gas is used to generate a gaseous nitrogen purge to the container.

### SUMMARY OF THE INVENTION

In general terms, the invention relates to a method of purifying a contaminated non-hermetically sealed transfer container, comprising: flowing a purge gas through a purifier to form a purified purge gas having a concentration of contaminants no greater than about 100 parts per trillion (ppt); and flowing the purified purge gas through the transfer container thereby to purge contamination from the transfer container.

In one example of the invention, a method of purifying a transfer container is described. The method comprises purging a non hermetically sealed transfer container with a gas having a contaminant concentration level no greater than about 100 parts per trillion (ppt), 10 ppt, or 1 ppt. The transfer container may include plastic, and may also be a standardized mechanical interface pod or a front opening unified pod. The contaminant in the gas used to purge the transfer container may be an organic contaminant, a hydrocarbon, an amines, an organophosphate, a siloxane, an inorganic acid, ammonia, or a combination of any of the aforementioned components. The gas used to purge the transfer container may include one or more of air, oxygen, or water. The gas may have a flow rate through the transfer container of less than about 300 standard liters per minute (slm), or the flow rate may be between about 5 slm and 200 slm. The gas may be introduced into the transfer container by ramping the flow rate starting at about 0 slm.

In another example of the invention, a method of transferring an object from a non hermetically sealed transfer container to a sealed chamber is described. The method includes the steps of purging the transfer container with a gas, exposing the transfer container to the sealed chamber, and transferring the object between the transfer container and the sealed chamber. The gas used to purge the transfer container has a contaminant concentration no greater than about 100 ppt. The method may further include the step of detecting the contaminant concentration of gas that is purged from the transfer container, the transfer container being exposed to the sealed chamber only when the detected contaminant concentration is no higher than a threshold contaminant concentration. The object to be transferred may be a semiconductor device or a wafer. The transfer container may have at least one non hermetically sealed container within the transfer container that holds the object to be transferred. The gas used to purge the transfer container may have a flow rate between about 100 slm and 10000 slm.

Another example of the invention is directed to another method of transferring an object from a non hermetically sealed transfer container to a sealed chamber. The method includes the steps of purging the transfer container with a gas, exposing the transfer container to the sealed chamber, and transferring the object between the transfer container and the sealed chamber. The gas used to purge the transfer container has a contaminant concentration below 2 parts per billion. The contaminant concentration is also low enough so that the sealed chamber has a lower concentration of contaminants upon being exposed to the transfer container than if the transfer container was not purged with the gas.

Another example of the invention is directed to a system for transferring an object between two environments. The system comprises a non hermetically sealed transfer container and a sealed chamber. The transfer container contains an environment that is purged with a gas having a contaminant concentration no greater than 100 ppt. The sealed chamber is connected to the transfer container. A closeable door separates the environment of the transfer container from the environment of the sealed chamber when the door is shut. A detector is optionally included and configured to identify the contaminant concentration of gas that is purged from the transfer container. The detector is also configured to send a signal to a controller for opening the closeable door when the contaminant concentration of the purged gas is no greater than a threshold concentration.

### BRIEF DESCRIPTION OF THE DRAWINGS

The foregoing and other objects, features and advantages of the invention will be apparent from the following more particular description of preferred embodiments of the invention, as illustrated in the accompanying drawings in which like reference characters refer to the same parts throughout the different views. The drawings are not necessarily to scale, emphasis instead being placed upon illustrating the principles of the invention.
FIG. 1 is a diagram illustrating process flow in a broad embodiment of the present invention.
FIG. 2 is a diagram illustrating process flow in a preferred embodiment of the present invention that incorporates feedback from a sensor.
FIG. 3A depicts a FOUP on the stage of an Isoport connected to a process tool wherein the FOUP may be purged by a method in accord with an embodiment of the present invention.
FIG. 3B depicts a SMIF pod on the stage of an Isoport connected to a process tool wherein the SMIF pod may be purged by a method in accord with an embodiment of the present invention.
FIG. 4 is a schematic of an experimental setup used to test the contamination level in a FOUP, some of the measurements utilizing a method in accord with an embodiment of the invention.
FIG. 5 graphs the result of the contaminant concentration in a FOUP during two different test conditions, one condition utilizing a method in accord with an embodiment of the invention.
FIG. 6 is a schematic of an experimental setup used to test the contamination level in various locations of a system in which a FOUP is connected to an IsoPort, some of the measurements utilizing a method in accord with an embodiment of the invention.
FIG. 7 is a schematic of an experimental setup used to examine the total contamination levels in a wafer chamber subject to different system configurations and environmental conditions, some of the measurements utilizing a method in accord with an embodiment of the invention.
FIG. 8A is an external view of a stocker, consistent with an embodiment of the invention.
FIG. 8B is a cross-sectional view of a stocker, consistent with an embodiment of the invention.

### DETAILED DESCRIPTION OF THE INVENTION

A description of preferred embodiments of the invention follows.

The use of standardized mechanical interface (SMIF) systems to control the microenvironment of sensitive devices during storage and transport within a fabrication facility has greatly improved process control and reduced device contamination. These improvements have produced higher yields of the devices and allowed for technological improvements that could not have been achieved if the devices were left in contact with the cleanroom environment. SMIF systems have played a particularly important role in the contamination control that enabled 130 nm integrated circuits and 300 mm ULSI wafers. As process improvements continue with the further implementation of these technology nodes and the drive toward future sub-micron technology nodes, contamination control becomes more crucial to the processes of semiconductor fabrication. Therefore, enhancements of the SMIF system that enable technological advancements and increase wafer yields are necessary.

While purging of SMIF systems, specifically SMIF pods and front opening unified pods (FOUPs), has been previously disclosed, its application was impractical prior to the present invention. Alternatives to purging have also been disclosed, but lack of control in these passive systems makes them less desirable for contamination control. Additionally, these methods are compatible with and complementary to actively purging the FOUP.

Embodiments of present invention solve the problems associated with purging FOUPs and provide an enhancement to the SMIF system that will enable future technological developments. Embodiments of the present invention utilize extremely pure purge gases, ≤100 ppt total organic contamination, preferably ≤10 ppt. This purity level was not readily attainable in most prior art methods. However, innovations in gas purification technology by the applicant have facilitated the availability of gas of said purity. Other embodiments of the present invention introduce the purge gas flow in a non instantaneous manner into the FOUP. It is relevant to note that teachings of these embodiments are contradictory to the application of purging as described in the prior art.

In one embodiment of the present invention, purge gas 4 is made to flow through a purifier 5 such that the contaminant concentration of the purge gas 6 is ≤ 100 ppt total organic contamination (TOC), preferably ≤10 ppt. A flow control device 3 causes purge gas flow 2 to increase from a zero flow condition to a desired flow rate 4 at a rate such that turbulent flow and the resulting particulate entrainment are sufficiently eliminated. Purge gas is then made to flow through a SMIF pod 7 that is a part of a SMIF system 1. Thus, in its broadest embodiment the method of the present invention overcomes the major obstacles to the purging of conveyance devices for the processing of devices susceptible to very low contaminant levels, e.g. semiconductor wafers or flat panel display substrates.

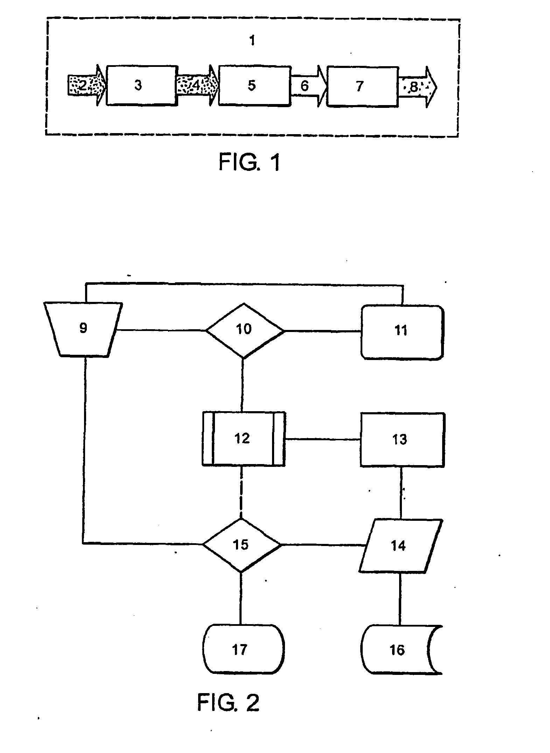

A preferred embodiment of the present invention involves the following steps as depicted in FIG. 2. A SMIF pod, preferably a FOUP, is connected to a SMIF system or component thereof, preferably an Isoport or similar device or a FOUP storage rack 9. This connection involves the kinematic alignment of a multipoint contact mechanism to ensure the proper placement of the FOUP 10. If the FOUP is not properly aligned 11, an error message results and the alignment must be reattempted. If the FOUP is properly aligned, a digital signal is transmitted to a flow control device 12, the operating parameters of which have been predefined, preferably this device is a digital pressure compensating mass flow controller (MFC). The gas then flows through a purifier to ensure that its purity is within the aforementioned range 13. The pure gas exiting the purifier flows into a FOUP via a valve between the FOUP and the SMIF system. It is preferred that the opening of said valve is also controlled, either actively or passively, by the proper alignment of the FOUP, for example as in devices previously disclosed by Asyst Technologies, see U.S. Patent Number 6,164,664 and references therein. The purge gas exits the FOUP through a valve similar to the inlet valve, and its contaminant concentration is monitored by a suitable analytical device downstream of this opening 14. When the contaminant concentration of the effluent reaches a predefined level, the analytical device transmits a digital signal to the SMIF system 15. This signal may be used by the system in a variety of manners, dependant upon the application. In some embodiments it may be stored to provide additional process control 16. In the preferred Isoport or similar device the signal results in the opening of the FOUP-process tool door by the Isoport 9. This signal may also be used by said digital MFC 12 to adjust purge gas flow through the FOUP to another predefined setpoint. Since wafers are normally continually removed from and returned to the FOUP, continuous purge gas monitoring 14 provides constant information about the environment of the nascent product. When all of the wafers have returned to the FOUP, the Isoport 9 closes the FOUP-process tool door. At this point an optional digital signal may be transmitted to the digital MFC 12 to adjust purge gas flow to a predefined setpoint. The contaminant concentration in the purge gas is again monitored 14 until it reaches an endpoint, at which time a digital signal provides notification that the FOUP is now ready for transport and/or storage 17.

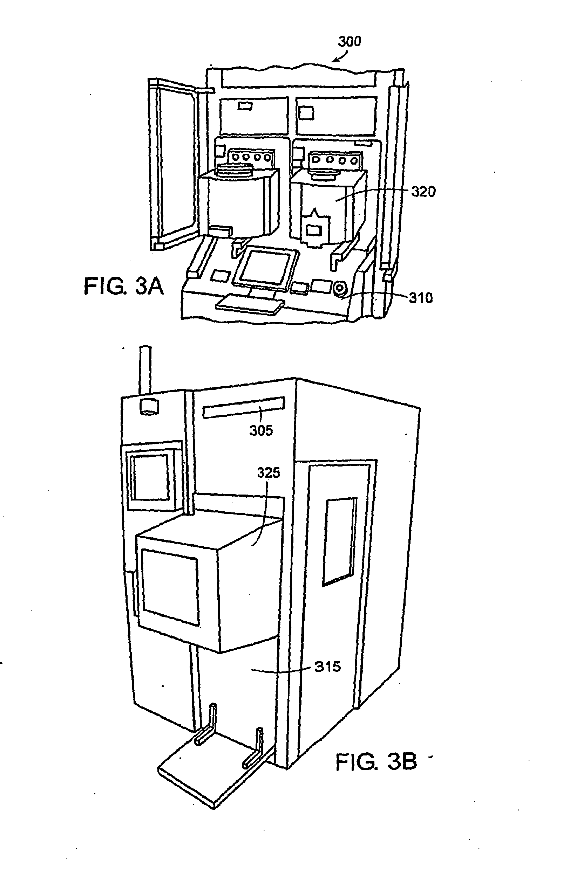

In FIG. 3A, the process tool 300 is depicted with attached load port 310, of which Isoport is one variety, with a FOUP 320 present on the stage of the load port. In an embodiment of the present invention the FOUP is purged through a port on the stage of the load port before, during, and/or after contact with the process tool has been established. According to the method, purge gas flow is introduced to FOUP with a total contaminant concentration < 100 ppt, preferably < 10 ppt, in a manner that sufficiently eliminates turbulent flow and the resulting particle entrainment in purge gas stream. Additionally, in FIG. 3B an alternative process tool 305 is depicted with attached load port 315 with a SMIF pod 325 present on the load port.

The present invention is not restricted to a specific purge gas. The nature of the gas used may vary according to the requirements of the manufacturing process and may be proprietary to the process or tool. Since SMIF pod purging has not been feasible prior to the present invention, the optimal purge gas may not be known to those skilled in the art. However, it is anticipated that the properties known to be optimal for gases used to purge similar environments will be applicable to the purging of FOUPs. Common purge gases used in other ultra high purity environments are nitrogen, argon, oxygen, air, and mixtures thereof. Recently, the applicant of the present invention has disclosed a novel purge gas found to possess considerable advantages over prior art practices for the purging of ultra high purity gas delivery lines and components. Furthermore, the use of said gas in the instant invention has been anticipated, although the methods of said use were unknown. Therefore, the preferred purge gas for use with the invention is extreme clean dry air (XCDA) as defined in the International Application Number PCT/US 20004/017251.

According to another embodiment of the present invention, the purge gas is purified such that the wafers, or other contamination susceptible devices, are not contaminated by said purge gas. A broad definition of this is that the purge gas is more pure than the ambient gas of the SMIF pod environment. Embodiments of the present invention are restricted to purge gases that effectively remove contaminants from the environment of the SMIF pod (e.g., purge gases with ≤100 ppt total organic contaminants, more preferably ≤10 ppt).

As previously disclosed by the applicant, the addition of certain oxygen containing species to purge gases, improves the effectiveness of a purge gas. Specifically, the addition of pure oxygen or water to oxygen-free or dry purge gases decreases the time required to reach a desired purity level of the effluent gas from a purged environment. It is speculated that the physical and chemical properties of O₂ and/or H₂O assist in the desorption of organic and other contaminants from an impure surface. Additionally, it is known to those skilled in the art that these oxygen containing species are necessary compounds in certain processes, such as the proper curing of photoresist polymers. Therefore, in certain embodiments of the present invention, water and/or oxygen may be added to the purge gas post purification. In these embodiments, the addition of these species will not result in diminished purity of the purge gas within the stated limits.

Though previously described embodiments of the invention are directed to purging wafer transfer containers such as FOUPs and other SMIF pods, it should be understood that the present invention can be practiced with more breadth. For example, the methods described by embodiments of the invention are not limited to purifying wafers and the environments of SMIF pods. The methods can be practiced with any transfer chamber that is non hermetically sealed. As well, the objects that are transferred and cleansed in the transfer container may be any semiconductor device, electronics manufacturing component, flat panel display component, or other object needing to be transferred to a purified sealed chamber (e.g., components of a high vacuum system).

One method, in accord with an embodiment of the invention, is directed to purifying a transfer container that is non hermetically sealed. The method comprises the step of purging the transfer container with a gas that has a contaminant concentration no greater than about 100 ppt.

Another embodiment of the invention is directed to a method of transferring an object from a non hermetically sealed transfer container to a sealed chamber. The method includes purging the transfer container with a gas that has a contaminant concentration no greater than about 100 ppt. Next the transfer container is exposed to the sealed chamber (e.g., by interfacing a port with a connector to allow the environments of the transfer container and sealed chamber to be in fluid communication). Finally the object is transferred between the transfer container and the sealed chamber; the object may be transferred in either direction. Optionally, the method includes the step of detecting a contaminant concentration of gas that has been purged from the transfer container. The environment of the transfer container is not exposed to the environment of the sealed chamber until the purged gas contaminant concentration is equal to or lower than a threshold concentration level.

In another embodiment of the invention, similar to the transfer method described above, the transfer container is purged with a gas. The contaminant concentration in the gas is below 2 ppb. The contaminant concentration is also low enough such that the contaminant exposure concentration in the sealed chamber, after the sealed chamber is exposed to the transfer container, is below what would be expected if the transfer container was not purged.

Another embodiment of the invention is directed to a system for transferring a semiconductor device. The system includes a non hermetically sealed transfer container having been purged with a gas having a concentration of contaminants no greater than about 100 parts per trillion. The system also includes a sealed chamber iri communication with the transfer container to allow the semiconductor device to be transferred between the sealed chamber and transfer container. Such an embodiment may also be practiced in a broadened context, wherein the object to be transferred between the transfer container and sealed chamber is not necessarily limited to a semiconductor device.

In another embodiment of the invention, a system for transferring an object between two environments comprises a transfer container and a sealed chamber. The transfer container is a non hermetically sealed container that is purged with a gas having a concentration of contaminants no greater than about 100 parts per trillion. The sealed chamber is connected with the transfer container. A closable door separates the environment of the sealed chamber from the environment of the transfer container when the door is closed. A detector is optionally included. The detector is configured to identify the contaminant concentration of the gas that is purged from the transfer container. When the contaminant concentration is equal to or below a threshold level, the detector is configured to send a signal to a controller that opens the closeable door. Subsequently, an object, such as a wafer or other semiconductor device, may be passed between the transfer container and sealed chamber.

Sealed chambers, used with the aforementioned embodiments, include chambers with an inner environment that is hermetically sealed from an exterior environment. Such chambers are constructed with walls that are gas impermeable (e.g., stainless steel). Thus, leakage of contaminants into the chamber is limited to where a port connects to another environment. Sealed chambers include semiconductor process tools (e.g., a photolithography tool) and other containment vessels, which may sustain a vacuum or other condition separate from the open atmosphere.

The transfer container used with embodiments of the invention are not limited to FOUPs or other types of SMIF pods. The transfer container may be constructed with materials such as plastics (e.g., polycarbonate or polypropylene). Since the transfer container is not hermetically sealed, contaminants may leech into the environment enclosed by the transfer container. As well, when plastics are utilized, off-gassing of the plastics may further contaminate the environment in the transfer container. Another source of contamination is the object transferred by the container. For examples, wafers may off-gas and desorb a substantial amount of contaminants to the transfer container environment while the wafer is being transferred. Thus, embodiments of the invention may enable purification of the environment of such transfer chambers as well as their contents.

Contaminants to be removed from a purge gas that is used with embodiments of the invention are not limited to organics, such as hydrocarbons, but include the range of contaminants of concern in high purity processing environments. Other examples include amines, organophosphates, siloxanes, inorganic acids, and ammonia. Any of these contaminants, or mixtures thereof, may need to be removed from a purge gas. As well, such contaminants may be removed during the purge of a transfer chamber.

Gases used to purge the transfer container in the above-described embodiments include any of the gases mentioned earlier in the SMIF pod and FOUP purifying embodiments. Types of purge gases include air (e.g., XCDA), oxygen, nitrogen, water, a noble gas (e.g., argon), and mixtures of such gases.

The concentration level of contaminants in the purge gas affects the ability of embodiments of the invention to purify transfer containers sufficiently to allow exposure to a sealed chamber without detrimentally contaminating the environment of the sealed chamber. Embodiments of the invention utilize purge gases with a contaminant concentration level no greater than about 100 ppt. In some embodiments of the invention, the contaminant concentration is no greater than about 10 ppt; no greater than about 1 ppt in another particular embodiment; and about 500 parts per quadrillion or lower in yet another particular embodiment.

The flow rate of a purge gas flowing into a transfer chamber also affects the purity of environment of the transfer container, and subsequently the purity of the sealed chamber after it is exposed to the contents of the transfer chamber. Embodiments of the invention utilize a purge gas flow rate less than about 300 standard liters per minute (slm), and a gas flow rate between about 3 slm and about 200 slm in a particular embodiment.

In related embodiments of the invention, when a transfer container is purged, the flow of purge gas may be introduced in a particular manner to suppress particulate contamination in the transfer container, and subsequently in the exposed sealed chamber. The flow of purge gas is ramped from a substantially no flow condition to the desired flow rate, as opposed to being introduced in a step-wise, or substantially instantaneous fashion. This flow may be achieved by utilizing a pressure compensating mass flow controller (MFC), or a pressure controller in conjunction with a calibrated orifice for gas introduction, or any other mechanism for controlling gas flow rates in high purity chambers as understood by those of ordinary skill in the art. Such controlled introduction of the purge gas helps suppress the development of turbulent gas flow and eddys that may enhance particulate transport and thus particulate contamination in the transfer chamber.

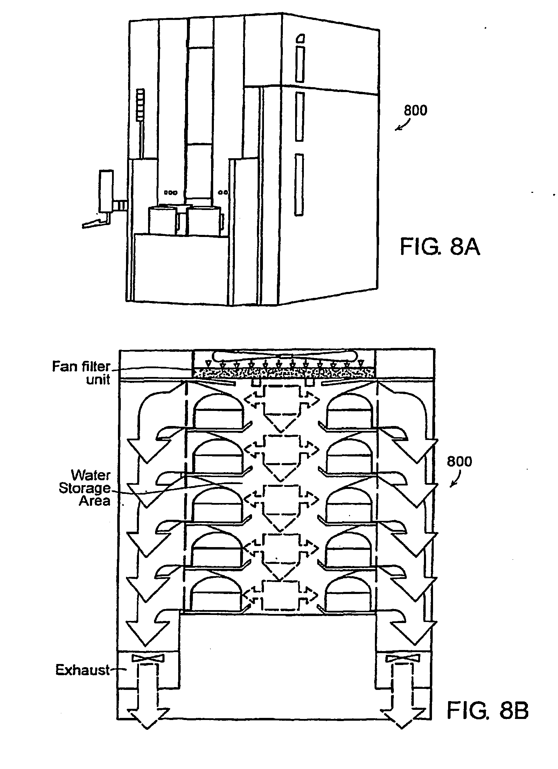

Alternate embodiments of the invention may utilize a transfer container that holds one or more non hermetically sealed transfer containers. For example, the transfer container may be a stocker 800 than contains one or more FOUPs or other types of SMIF pods as shown in FIGS. 8A and 8B. A stocker may carry 25 FOUPs to be inserted into the environment of a tool for subsequent distribution of the FOUPs' contents into the sealed chamber. In such an instance, the flow rate of purge gas utilized in such a transfer container may range from about 100 slm to about 10,000 slm. Such embodiments may allow the contents of FOUPs to remain protected from contamination for an extended period of time relative to FOUPs that are not subject to a purged stocker. For example, components of a Cu deposition process may only be exposed to air for about 16 hours before contamination degrades such components. When placed in a FOUP nested in a stocker, about 2 days may pass before the same degradation takes place.

### EXAMPLES

The following examples are meant to illustrate particular aspects of some embodiments of the invention. The examples are not intended to limit the scope of any particular embodiment of the invention that is utilized.

### Example 1: FOUP Atmosphere Testing

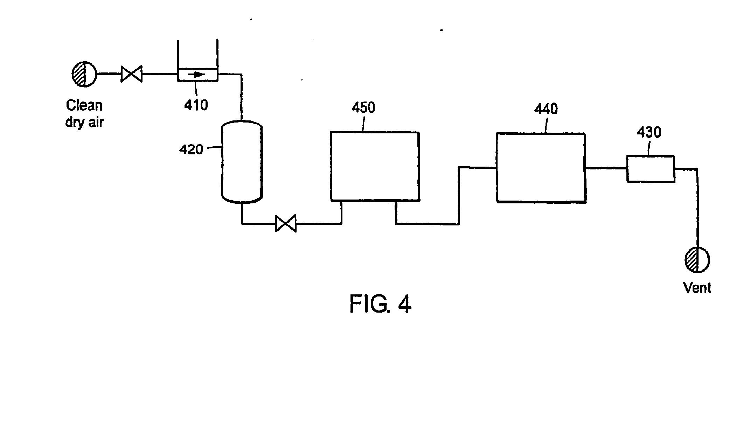

The atmosphere of a FOUP 450 was examined for hydrocarbon contaminants under static conditions and with a XCDA purge. The experimental setup for the FOUP contamination test is shown in FIG. 4. A mass flow controller 410 was used to maintain a flow rate of the purge gas at 5 slm. The clean dry air (CDA) gas was purified with an Aeronex CE500KFO4R gas purifier (Mykrolis Corporation, Billerica, Massachusetts) 420 to generate purge gas having a contaminant concentration below 1 ppt. A vacuum pump 430 was used downstream of the cold trap 440 for sample collection. The difference in pressure and flow rate was factored in when the concentration of contaminants was calculated with a calibration curve for a combined contaminant set of benzene, toluene, ethylbenzene, and xylenes (BTEX).

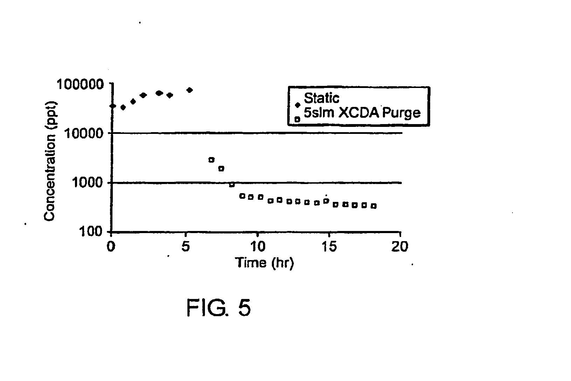

The results from the FOUP experiment are shown in FIG. 5. Under static conditions, the combined non methane hydrocarbon (NMHC) concentration was 71 ppb within the FOUP before the XCDA purge was started. Once phase equilibrium was reached within the FOUP, the average combined total hydrocarbon (THC) concentration was 357 ppt under the purge gas.

### Example 2: Load Port and FOUP Test

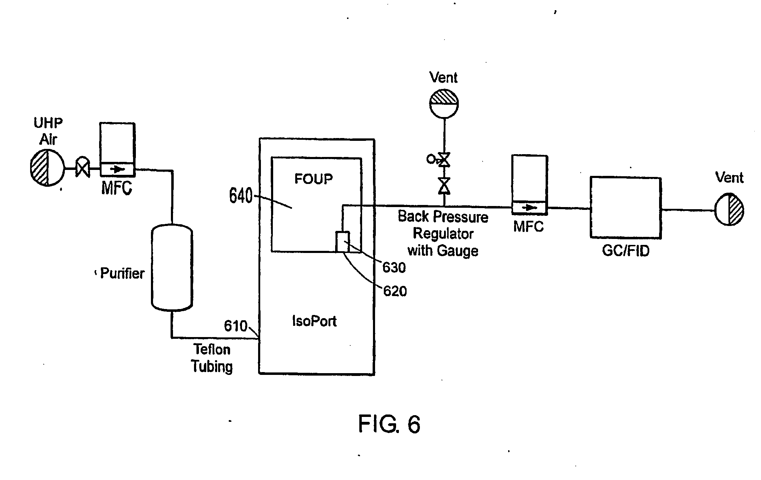

The experimental system depicted in FIG. 6 was used in another test run. Four measurements of the concentration of hydrocarbon contamination were taken:
(i) at the exit of the load port delivery system, a sample was taken by hard plumbing to Teflon tubing (see location 610 in FIG. 6); (ii) at the outlet of the load port via the FOUP quick connect (see location 620 in FIG. 6); (iii) internal to the FOUP at the purge inlet filter (see location 630 in FIG. 6); and (iv) internal to the FOUP to measure bulk background without purging (see location 640 in FIG. 6).

A MFC was used to maintain a flow rate of the purge gas at 25 slm for locations 610, 620, 630 in FIG. 6. The CDA gas was purified with an Aeronex CE500KFO4R gas purifier (Mykrolis Corporation, Billerica, Massachusetts) to generate purified purge gas having a contaminant concentration below 1 ppt. The gas was allowed to flow through only one of the load port gas outlets. Gas flow was terminated while the THC concentration levels of the FOUP under static conditions were measured (location 640). The concentration method was used to measure hydrocarbons to ppt concentration levels.

For measurement (i), the Teflon tubing was connected directly to the GC/FID. A backpressure regulator was used to maintain a pressure of 30 psig during this test and a MFC was used to maintain a sample flow rate of 0.75 slim

Since a hard-plumbed connection could not be made to locations 620, 630, 640 of FIG. 6, a custom stainless steel shroud was constructed to allow for sampling at those locations. The sampling shroud enabled connection to the FOUP and load port so that samples could be sent to the GC/FID. A pump had to be used downstream of the GC/FID to collect samples for locations 620, 630, 640. Therefore, the difference in pressure and flow rate had to be factored in when the concentration was calculated using the BTEX calibration curve.

The results from the load port and FOUP test are summarized in Table 1 in terms of the average concentration of contaminant hydrocarbons (C_{HCs}) measured at the various locations. As shown in the table, location 610 was not a significant source of contamination.

**Table 1: Summary of the Load Port and FOUP Test Results**

| **Measurement** | **Point of Analysis** | **Average C_{HCs} (ppt)** |
|---|---|---|
| (i) | Teflon | 6 |
| (ii) | Teflon & Load Port | 236 |
| (iii) | Teflon & Load Port + FOUP | 248 |
| (iv) | FOUP (Static) | 224010 |

### Example 3: Wafer Storage Experiment

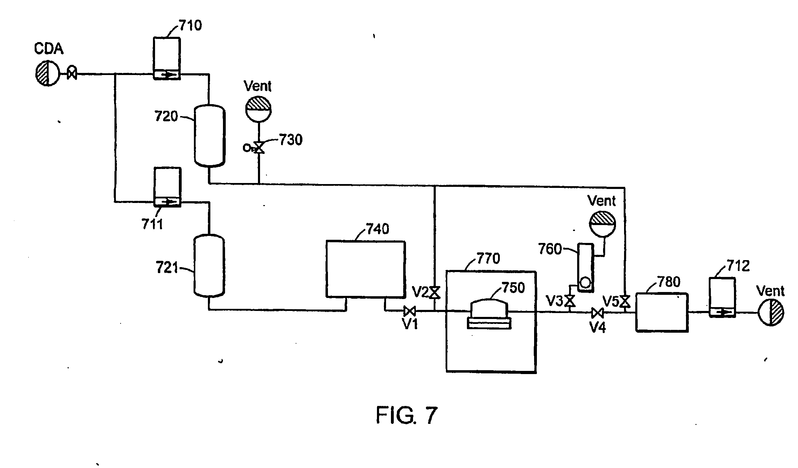

FIG. 7 is a schematic of the experimental setup used to measure wafer contamination due to exposure to the FOUP environment under static and various purge gas conditions. The main purpose of this setup is to eliminate the exposure of the wafer to the surrounding environment before desorption of the hydrocarbons; therefore, all contamination on the wafer would be directly from the FOUP environment.

MFCs 710, 711, 712 were used to maintain a flow rate of the air during the experiment. The air was purified with an Aeronex CE500KFO4R purifier 720, 721 to provide a XCDA gas stream having a contaminant concentration below 1 ppt. The gas stream to the instrument and for sample measurement was pressurized to 30 psig with a backpressure regulator 730. Since the FOUP 740 is not hermetically sealed, the gas stream to it was at atmospheric pressure. The wafer chamber 750 was composed of stainless steel, A rotameter 760 was used to determine the flow from the FOUP 740 to the wafer chamber 750. The wafer chamber's operating temperature was maintained with an environmental chamber 770. The GC/FID 780 was used to measure hydrocarbons in the gas samples. A cold trap was used to measure the hydrocarbons at ppt concentration levels. The lower detection limit (LDL) for the cold trap method is 1 ppt. A MFC 712 was used to maintain the sample flow rate through the GC/FID 780 at 0.75 slm. The tubing between the FOUP and the GC/FID and valves V1 through V5 was coated with Sulfinert.

Measurements of wafer contamination were made under three different conditions:
1. The FOUP under static conditions for seven days.
2. The FOUP under purge conditions for seven days using XCDA.
3. The FOUP under purge conditions for seven days using UHP CDA.

During all three measurements, valve V5 was left open to allow XCDA gas to purge the tubing downstream of valve V4. For measurement 1, the inlet to the FOUP was capped. Valve V1 was opened and valves V2, V3, and V4 were closed to expose the wafer chamber to the FOUP environment. For measurements 2 and 3, valves V1 and V3 were opened and valves V2 and V4 were closed to allow the purge gas to flow at 5 slm through the FOUP. The purge gas flow rate through the wafer chamber and out to vent was about 3.0 to about 3.5 slm. The rotameter was used to determine how much gas was actually flowing through the FOUP and to the wafer chamber. After the seven-day test period for each of the three measurements, the wafer chamber was isolated and heated to 150°C. Once this temperature reached, samples were collected by closing valve V5 and opening valves V2 and V4. Between sample collections, the wafer chamber was isolated so that all of the hydrocarbons released could be captured for measurement.

The results from all three measurements are summarized in Table 2 in terms of the total volume of non methane hydrocarbons (NMHCs) collected from the wafer.

**Table 2: Summary for Wafer Storage Experiment**

| **Experimental Conditions** | **Wafer Contamination (nl)** |
|---|---|
| Static | 421.817 |
| XCDA Purge Gas | 70.241 |
| UHP CDA Purge Gas | 1096.621 |

The results indicate that XCDA purge gas conditions are more efficient at limiting and removing hydrocarbons from the wafer's surface than static and UHP CDA purge gas conditions. Due to the hydrocarbon's present in the UHP CDA purge gas, more hydrocarbons are loaded onto the wafer under this method than under static conditions. Prior to performing the UHP CDA purge conditions, the hydrocarbon concentration in the UHP CDA was measured at 15 ppt. Therefore, purging with an unpurified gas will add hydrocarbon contamination to the wafer and not prevent it.

While this invention has been particularly shown and described with references to preferred embodiments thereof, it will be understood by those skilled in the art that various changes in form and details may be made therein without departing from the scope of the invention encompassed by the appended claims.

## Claims

1. A method of purifying a contaminated non-hermetically sealed transfer container, comprising:
flowing a purge gas (4) through a purifier (5) to form a purified purge gas (6) having a concentration of contaminants no greater than 100 parts per trillion, wherein the purge gas includes at least one of air, oxygen or water; and
flowing the purified purge gas through the transfer container (7, 10) thereby to purge contamination from the transfer container.

2. The method of Claim 1, wherein the transfer container comprises plastic, the plastic contacting the gas inside the transfer container.

3. The method of Claim 1, wherein the contamination present in the contaminated transfer container includes at least one organic contaminant.

4. The method of Claim 1, wherein the contamination present in the contaminated transfer container includes at least one of hydrocarbons, amines, organophosphates, siloxanes, inorganic acids, and ammonia.

5. The method of Claim 1, wherein the gas has a flow rate through the transfer container of less than about 300 standard liters per minute or the gas has a flow rate through the transfer container between 5 slm and 200 slm.

6. The method of Claim 1 wherein the gas is extreme clean dry air.

7. The method of Claim 5, wherein the flow rate is ramped starting from 0 slm.

8. The method of Claim 1, wherein the concentration of contaminants in the gas is: (a) no greater than 10 ppt; or (b) no greater than 1 ppt.

9. The method of Claim 1, wherein the transfer container is either a front opening unified pod (10), or a standardized mechanical interface pod (7).

## Patentansprüche

1. Verfahren zum Reinigen von kontaminierten nicht hermetisch abgeriegelten Transportbehältern, das folgendes aufweist:
ein Säuberungsgas (4) wird durch einen Reiniger (5) gespült, um ein gereinigtes Säuberungsgas (6) zu erhalten mit einer Konzentration an Kontaminanten, die nicht größer als 100 Anteile pro einer Trillion, und in welcher das Säuberungsgas mindestens Luft, Sauerstoff oder Wasser beinhaltet;
und
das gereinigte Säuberungsgas durch den Transportbehälter (7, 10) gespült wird, um dabei die Verunreinigung aus dem Transportbehälter zu entfernen.

2. Verfahren nach Anspruch 1, bei dem der Transportbehälter aus Kunststoff besteht und der Kunststoff das Gas in dem Transportbehälter kontaktiert.

3. Verfahren nach Anspruch 1, bei dem die gegenwärtige Verunreinigung in dem verunreinigten Transportbehälter zumindest eine organische Verunreinigung umfasst.

4. Verfahren nach Anspruch 1, bei dem die gegenwärtige Verunreinigung in dem verunreinigten Transportbehälter zumindest einen der Stoffe Kohlenwasserstoffe, Amine, Organphosphate, Siloxane, anorganische Säuren und Ammoniak umfasst.

5. Verfahren nach Anspruch 1, bei dem das Gas eine Fließrate durch den Transportbehälter von nicht weniger als 300 Standard-Liter pro Minute (slm) hat oder das Gas eine Fließrate durch den Transportbehälter zwischen 5 slm und 200 slm hat.

6. Verfahren nach Anspruch 1, bei dem das Gas extrem saubere trockene Luft ist.

7. Verfahren nach Anspruch 5, bei dem die Fließrate aufgerichtet von 0 slm startet.

8. Verfahren nach Anspruch 1, bei dem die Konzentration an Verunreinigungen in dem Gas: (a) nicht größer als 10 ppt ist; oder (b) nicht größer als 1 ppt ist.

9. Verfahren nach Anspruch 1, bei dem der Transportbehälter entweder eine vereinheitlichte Frontöffnungsbaugruppe (10) oder eine standardisierte mechanische Schnittsteilenbaugruppe (7) ist.

## Revendications

1. Procédé de purification d'un conteneur de transfert contaminé non-hermétiquement scellé, comprenant les étapes suivantes :
faire circuler un gaz de purge (4) à travers un épurateur (5) en vue d'obtenir un gaz de purge purifié (6) dont la teneur en contaminants est inférieure ou égale à 100 parties par trillion, ledit gaz de purge comprenant au moins un des éléments suivants : air, oxygène, eau ; et
faire circuler le gaz de purge purifié à travers le conteneur de transfert (7, 10) en vue de purger ledit conteneur de transfert de toute contamination.

2. Procédé selon la revendication 1, dans lequel le conteneur de transfert comporte de la matière plastique, ladite matière plastique étant en contact avec le gaz à l'intérieur du conteneur de transfert.

3. Procédé selon la revendication 1, dans lequel la contamination présente dans le conteneur de transfert contaminé comprend au moins un contaminant organique.

4. Procédé selon la revendication 1, dans lequel la contamination présente dans le conteneur de transfert contaminé comprend au moins un des éléments suivants : hydrocarbures, amines, phosphates organiques, siloxanes, acides minéraux et ammoniac.

5. Procédé selon la revendication 1, dans lequel le gaz circule à travers le conteneur de transfert avec un débit inférieur à environ 300 litres standard par minute ou compris entre 5 et 200 litres standard par minute.

6. Procédé selon la revendication 1, dans lequel le gaz est de l'air sec extrêmement propre.

7. Procédé selon la revendication 5, dans lequel on augmente le débit à partir de 0 litre standard par minute.

8. Procédé selon la revendication 1, dans lequel la teneur du gaz en contaminants est : (a) inférieure ou égale à 10 ppt ; ou (b) inférieure ou égale à 1 ppt.

9. Procédé selon la revendication 1, dans lequel le conteneur de transfert est soit une enceinte de transport unifiée à ouverture frontale
(10), soit une enceinte de transport à interface mécanique standard (7).
